# EUROPÄISCHE PATENTSCHRIFT

(11) **EP 2 641 457 B1**
(45) Veröffentlichungstag und Bekanntmachung des Hinweises auf die Patenterteilung: **15.10.2014**
(21) Anmeldenummer: 11794620.2
(22) Anmeldetag: 16.11.2011
(51) Int. Cl.: H05K 1/18, H05K 3/32, H05K 1/14, H05K 3/40

(54) **VERFAHREN ZUM FESTLEGEN EINES BAUTEILS IN BZW. AN EINER LEITERPLATTE SOWIE LEITERPLATTE**
METHOD FOR MOUNTING A COMPONENT IN OR ON A CIRCUIT BOARD, AND CIRCUIT BOARD
PROCÉDÉ DE FIXATION D'UN COMPOSANT DANS OU SUR UNE CARTE DE CIRCUIT ET CARTE DE CIRCUIT CORRESPONDANTE

(30) Priorität: 19.11.2010 AT 7092010
(43) Veröffentlichungstag der Anmeldung: 25.09.2013
(73) Patentinhaber: AT & S Austria Technologie & Systemtechnik Aktiengesellschaft, 8700 Leoben-Hinterberg (AT)
(72) Erfinder: WEICHSLBERGER, Günther, A-8043 Graz (AT); DROFENIK, Dietmar, A-8740 Spielberg (AT)
(74) Vertreter: Miksovsky, Alexander
(86) Internationale Anmeldenummer: PCT/AT2011/000464
(87) Internationale Veröffentlichungsnummer: WO 2012/065202

(56) Entgegenhaltungen:
- DE-A1-102008 050 798
- US-A- 3 670 394
- US-A- 5 354 392
- US-A1- 2006 078 715
- US-A1- 2008 150 132
- US-A1- 2009 314 522

## Beschreibung

Die vorliegende Erfindung bezieht sich auf ein Verfahren zum Festlegen eines wenigstens eine metallische Oberfläche aufweisenden Elements bzw. Bauteils in bzw. an einer Leiterplatte, welche wenigstens eine leitende Schicht aus metallischem Material enthält, wobei eine Verbindung zwischen der wenigstens einen metallischen Oberfläche des Elements und der wenigstens einen leitenden Schicht der Leiterplatte durch ein Ultraschallschweißen bzw. hochfrequentes Reibschweißen durchgeführt wird, sowie auf eine Leiterplatte, welche wenigstens eine leitende Schicht aus metallischem Material enthält, wobei die Leiterplatte ein wenigstens eine metallische Oberfläche aufweisendes Element bzw. Bauteil umfasst, wobei die metallische Oberfläche des Elements bzw. Bauteils mit der wenigstens einen leitenden Schicht der Leiterplatte durch ein Ultraschallschweißen bzw. hochfrequentes Reibschweißen verbunden bzw. verbindbar ist.

Im Zusammenhang mit einem Festlegen eines wenigstens eine metallische Oberfläche aufweisenden Elements bzw. Bauteils in bzw. an einer Leiterplatte sind unterschiedliche Verfahrensführungen, wie beispielsweise ein Löten oder ein Kleben bekannt. Nachteilig bei einem Verlöten von metallischen Oberflächen bzw. leitenden Schichten aus metallischem Material einer Leiterplatte ist ein vergleichsweise hoher Arbeitsaufwand. Darüber hinaus sind Lötvorgänge insbesondere bei aus unterschiedlichen Materialien bestehenden, miteinander zu verbindenden Flächen bzw. Oberflächen teilweise überaus kompliziert und teilweise nahezu undurchführbar. Bei einem Verkleben von derartigen, miteinander zu verbindenden Flächen bzw. Oberflächen ist oftmals nachteilig, dass durch Verklebungen eine ausreichende Sicherheit und Festigkeit bei erhöhten oder lang andauernden Beanspruchungen nicht ohne weiteres sichergestellt bzw. zur Verfügung gestellt werden kann. Darüber hinaus ist beispielsweise eine gute thermisch oder elektrisch leitende Verbindung durch Verklebung selbst bei Einsatz von spezielle Leitfähigkeiten aufweisenden Klebern nicht bzw. nicht ohne weiteres möglich.

Zur teilweisen Behebung der Nachteile eines Verlötens, wie sie oben erläutert wurden, wurde gemäß der US 2009/0314522 A1 oder der US 2008/0150132 A1 für eine Verbindung zwischen metallischen Schichten bzw. Lagen bei der Herstellung von Leiterplatten der Einsatz eines Ultraschweißens oder Reibschweißens vorgeschlagen, wie dies auch dem eingangs genannten Verfahren oder der eingangs genannten Leiterplatte entspricht.

Ähnliche Ausführungsformen sind beispielsweise auch der US 2006/0078715 A1, der DE 10 2008 050 798 A1, der US 3 670 394 A oder der US 5 354 392 A entnehmbar.

Die vorliegende Erfindung zielt darauf ab, die Probleme des bekannten Standes der Technik bei einer Verbindung einer metallischen Oberfläche eines in bzw. an einer Leiterplatte festzulegenden Bauteils bzw. Elements und einer leitenden Schicht einer Leiterplatte zu vermeiden oder zumindest zu reduzieren, wobei insbesondere darauf abgezielt wird, eine zuverlässige, mechanisch beanspruchbare und eine entsprechende Leitfähigkeit zur Verfügung stellende Verbindung zu ermöglichen.

Zur Lösung dieser Aufgaben ist ein Verfahren der eingangs genannten Art im wesentlichen dadurch gekennzeichnet, dass das in bzw. an der Leiterplatte festgelegte Element von einem Bi- oder Trimetallsubstrat gebildet ist, wobei eine zu der wenigstens einen Schicht aus leitendem Material der Leiterplatte gerichtete Schicht des Elements aus Kupfer oder einer Cu-haltigen Legierung gebildet wird. Durch Einsetzen eines Ultraschallschweißens bzw. hochfrequenten Reibschweißens zum Verbinden wenigstens einer metallischen Oberfläche eines in bzw. an der Leiterplatte festzulegenden, von einem Bi- oder Trimetallsubstrat gebildeten Elements bzw. Bauteils und der wenigstens einen leitenden Schicht der Leiterplatte wird eine nicht nur mechanisch stabile Verbindung zwischen den miteinander zu verbindenden Flächen bzw. Oberflächen zur Verfügung gestellt, sondern es kann durch die hergestellte Verbindung auch eine entsprechend gute elektrische als auch gegebenenfalls erforderliche thermische Leitfähigkeit zur Verfügung gestellt werden. Bei einem derartigen Ultraschallschweißen bzw. hochfrequenten Reibschweißen wird die für eine Verbindung nötige Wärme durch eine hochfrequente mechanische Schwingung erreicht, welche zwischen den miteinander zu verbindenden Bauteilen bzw. Flächen oder Oberflächen durch eine Molekular- und Grenzflächenreibung entsteht. Die erforderliche hochfrequente Schwingung wird beispielsweise mit einer Sonotrode bzw. einem Hochfrequenz-Schwingkopf zur Verfügung gestellt, wobei die Schwingungen unter Druck auf die miteinander zu verbindenden Elemente bzw. Bauteile übertragen werden. Hiebei beginnen sich zumindest die Oberflächen der miteinander zu verbindenden Elemente durch die entstehende Reibung zu erwärmen, wobei die miteinander zu verbindenden Flächen bzw. Oberflächen der Bauteile nicht bis zu einem Schmelzen erhitzt werden und üblicherweise eine Verbindung der miteinander zu verbindenden Flächen bzw. Oberflächen insbesondere einem Aufbrechen einer Oxidschicht im wesentlichen durch eine Verzahnung der Oberflächen der miteinander zu verbindenden Elemente bzw. Oberflächen bereitgestellt wird. Es lässt sich bei entsprechender Schonung des mit der Leiterplatte zu verbindenden Bauteils bzw. Elements als auch gegebenenfalls bestehender Strukturen der Leiterplatte eine mechanisch sichere Verbindung wenigstens einer leitenden Schicht der Leiterplatte mit dem damit zu verbindenden Element bzw. Bauteil zur Verfügung stellen. Für eine besonders zuverlässige und gute Kopplung mit der leitenden bzw. leitfähigen Schicht der Leiterplatte wird somit erfindungsgemäß vorgeschlagen, dass das in bzw. an der Leiterplatte festgelegte Element von einem Bi- oder Trimetallsubstrat gebildet ist, wobei eine zu der wenigstens einen Schicht aus leitendem Material der Leiterplatte gerichtete Schicht des Elements aus Kupfer oder einer Cu-haltigen Legierung gebildet wird.

Für eine Kopplung mit einem externen Bauteil bzw. beispielsweise einer Anschluss- oder Kontaktstelle eines derartigen externen Bauteils wird gemäß einer bevorzugten Ausführungsform vorgeschlagen, dass eine von der zu der wenigstens einen Schicht aus leitendem Material der Leiterplatte gerichteten Schicht abgewandte Schicht des Elements aus einem von Kupfer verschiedenen Metall, insbesondere aus Aluminium oder einer Aluminiumlegierung gebildet wird.

Zur Unterstützung einer zuverlässigen und stabilen mechanischen Verbindung insbesondere bei Leiterplatten, welche großen Temperaturbeanspruchungen und hohen Temperaturunterschieden ausgesetzt sind, und/oder um ein Lösung bzw. eine Zerstörung der Verbindung bei derart unterschiedlichen Temperaturen zu vermeiden, wird gemäß einer weiters bevorzugten Ausführungsform vorgeschlagen, dass das Leiterplattenelement aus Metallen mit einer hohen, im wesentlichen ähnlichen bzw. gleichen Wärmeleitfähigkeit gebildet wird.

Zur Bereitstellung einer gewünschten Leitfähigkeit als auch für eine mechanisch stabile Verbindung wird gemäß einer bevorzugten Ausführungsform vorgeschlagen, dass eine im wesentlichen vollflächige Verbindung zwischen der metallischen Oberfläche des Elements und der leitenden Schicht der Leiterplatte ausgebildet wird.

Bei einem Einfügen eines Elements bzw. Bauteils in eine Leiterplatte und/oder zum Einbetten eines derartigen Elements bzw. Bauteils, welches auch im wesentlichen an einer außenliegenden Oberfläche an einer Leiterplatte angeordnet sein kann, wird vorgeschlagen, dass nach einer Verbindung zwischen der metallischen Oberfläche des Elements und der leitenden Schicht der Leiterplatte eine wenigstens teilweise Ummantelung bzw. Einbettung des mit der leitenden Schicht der Leiterplatte verbundenen Elements ausgebildet wird, wie dies einer weiteren bevorzugten Ausführungsform des erfindungsgemäßen Verfahrens entspricht.

Während ein in bzw. an der Leiterplatte festzulegendes Element beispielsweise für eine Wärmeabfuhr bzw. Ableitung zu einem Kühlkörper dienen kann, ist oftmals eine Einbettung bzw. Aufnahme von mit zusätzlichen Kontakten versehenen Bauteilen in bzw. an einer Leiterplatte vorgesehen. Für eine Kontaktierung nach einer erfindungsgemäß vorgesehenen Festlegung durch ein Ultraschallschweißen bzw. ein hochfrequentes Reibschweißen wird gemäß einer weiteren bevorzugten Ausführungsform vorgeschlagen, dass insbesondere nach der Verbindung, insbesondere nach einer Ummantelung bzw. Einbettung des mit der leitenden Schicht der Leiterplatte verbundenen Elements in an sich bekannter Weise eine Kontaktierung des Elements vorgenommen wird.

Neben einer unmittelbaren Kopplung zwischen einem Element bzw. Bauteil und einer leitenden bzw. leitfähigen Schicht einer Leiterplatte ist beispielsweise zur Bereitstellung einer Verbindung mit einem externen Bauteil, welcher mit von einem Material für die leitende bzw. leitfähige Schicht der Leiterplatte verschiedenen Material gebildeten Anschlussstellen oder Kontakten versehen ist, beispielsweise erforderlich, mehrlagige Verbundelemente zur Verfügung zu stellen, welche eine Kopplung mit derartigen unterschiedlichen Materialien ermöglichen. Im Zusammenhang mit dem erfindungsgemäßen Verfahren im Hinblick auf eine mechanisch stabile und eine gute Leitfähigkeit aufweisende Verbindung zwischen einem Element bzw. Bauteil und einer leitenden bzw. leitfähigen Schicht einer Leiterplatte wird gemäß einer weiters bevorzugten Ausführungsform des erfindungsgemäßen Verfahrens vorgeschlagen, dass das Element von einem Leiterplattenelement gebildet wird, welches wenigstens zwei Schichten bzw. Lagen aus unterschiedlichen leitenden Materialien, insbesondere Metallen, enthält bzw. daraus besteht. Für eine Kopplung mit einem externen Element bzw. Bauteil wird hierbei gemäß einer weiters bevorzugten Ausführungsform vorgeschlagen, dass die metallische Oberfläche oder eine Lage des in bzw. an der Leiterplatte festgelegten Elements mit einem externen Bauteil verbunden wird.

Insbesondere entsprechend gegebenenfalls unterschiedlichen miteinander zu kombinierenden Materialen bzw. Metallen wird in diesem Zusammenhang gemäß einer weiters bevorzugten Ausführungsform vorgeschlagen, dass die metallische Oberfläche bzw. wenigstens eine Schicht bzw. Lage des in bzw. an der Leiterplatte festgelegten Elements gewählt wird aus der Gruppe, umfassend Kupfer, Aluminium, Nickel, Zinn, Zink, Titan, Silber, Gold, Palladium, Vanadium, Chrom, Magnesium, Eisen, Stahl, Edelstahl und Indium als Reinmaterial oder Legierung(en) hievon.

Zur Lösung der oben angegebenen Aufgaben ist eine Leiterplatte der eingangs genannten Art im wesentlichen dadurch gekennzeichnet, dass das in bzw. an der Leiterplatte festgelegte Element von einem Bi- oder Trimetallsubstrat gebildet ist, wobei eine zu einer Schicht aus leitendem Material der Leiterplatte gerichtete Schicht aus Kupfer oder einer Cu-haltigen Legierung gebildet ist. Wie bereits oben ausgeführt, lässt sich in zuverlässiger und einfacher Weise eine nicht nur mechanisch stabile Verbindung mit einer metallischen Oberfläche eines in bzw. an der Leiterplatte festzulegenden, von einem Bi- oder Trimetallsubstrat gebildeten Elements bzw. Bauteils, sondern eine entsprechend gute Leitfähigkeit einer derartigen Verbindung zur Verfügung stellen. Für eine besonders gute Kopplung mit der leitenden bzw. leitfähigen Schicht der Leiterplatte wird erfindungsgemäß vorgeschlagen, dass das in bzw. an der Leiterplatte festgelegte Element von einem Bi- oder Trimetallsubstrat gebildet ist, wobei eine zu einer Schicht aus leitendem Material der Leiterplatte gerichtete Schicht aus Kupfer oder einer Cu-haltigen Legierung gebildet ist.

Insbesondere in Abhängigkeit von dem Material des mit der Leiterplatte zusätzlich zu koppelnden externen Bauteils wird darüber hinaus bevorzugt vorgeschlagen, dass eine von der zu der wenigstens einen Schicht aus leitendem Material der Leiterplatte gerichteten Schicht abgewandte Schicht des Leiterplattenelements aus einem von Kupfer verschiedenen Metall, insbesondere aus Aluminium oder einer Aluminiumlegierung gebildet ist.

Zur Aufrechterhaltung einer mechanischen stabilen Verbindung insbesondere bei wechselnden Temperaturbeanspruchungen und/oder hohen Temperaturunterschieden wird darüber hinaus vorgeschlagen, dass das Leiterplattenelement aus Metallen mit einer hohen, im wesentlichen ähnlichen bzw. gleichen Wärmeleitfähigkeit gebildet ist, wie dies einer weiters bevorzugten Ausführungsform der erfindungsgemäßen Leiterplatte entspricht.

Zur Erzielung einer guten mechanischen Festigkeit der Verbindung als auch einer gegebenenfalls zusätzlich erforderlichen, großen verbundenen Oberfläche zur Bereitstellung einer gewünschten Leitfähigkeit wird gemäß einer weiters bevorzugten Ausführungsform vorgeschlagen, dass eine im wesentlichen vollflächige Verbindung zwischen der metallischen Oberfläche des Elements und der leitenden Schicht der Leiterplatte vorgesehen ist.

Insbesondere zur Kopplung mit externen Bauteilen, welche gegebenenfalls aus von einem Material einer leitenden bzw. einer leitfähigen Schicht einer Leiterplatte verschiedenen Materialien bestehen, wird gemäß einer weiters bevorzugten Ausführungsform vorgeschlagen, dass das Element von einem Leiterplattenelement gebildet ist, welches wenigstens zwei Schichten bzw. Lagen aus unterschiedlichen leitenden Materialien, insbesondere Metallen, enthält oder daraus besteht.

Für eine besonders zuverlässige Kopplung mit der wenigstens einen leitenden bzw. leitfähigen Schicht der Leiterplatte wird darüber hinaus vorgeschlagen, dass die metallische Oberfläche bzw. wenigstens eine Schicht bzw. Lage des in bzw. an der Leiterplatte festgelegten Elements gewählt ist aus der Gruppe, umfassend Kupfer, Aluminium, Nickel, Zinn, Zink, Titan, Silber, Gold, Palladium, Vanadium, Chrom, Magnesium, Eisen, Stahl, Edelstahl und Indium als Reinmaterial oder Legierung(en) hievon, wie dies einer weiters bevorzugten Ausführungsform der erfindungsgemäßen Leiterplatte entspricht.

Die Erfindung wird nachfolgend anhand von in der beiliegenden Zeichnung schematisch dargestellten Ausführungsbeispielen näher erläutert. In dieser zeigen:
Fig. 1a bis 1d unterschiedliche Schritte eines erfindungsgemäßen Verfahrens zum Festlegen eines Bauteils bzw. Elements in bzw. an einer Leiterplatte zur Herstellung einer erfindungsgemäßen Leiterplatte;
Fig. 2a und 2b schematische Darstellungen einer Festlegung eines mehrlagigen Elements in bzw. an einer erfindungsgemäßen Leiterplatte unter Einsatz des erfindungsgemäßen Verfahrens; und
Fig. 3 eine abgewandelte Ausführungsform einer erfindungsgemäßen Leiterplatte zur Kopplung mit einer externen Energieversorgung unter Verwendung eines wiederum mehrlagigen Elements bzw. Bauteils, welches entsprechend dem erfindungsgemäßen Verfahren an der Leiterplatte festgelegt wurde.

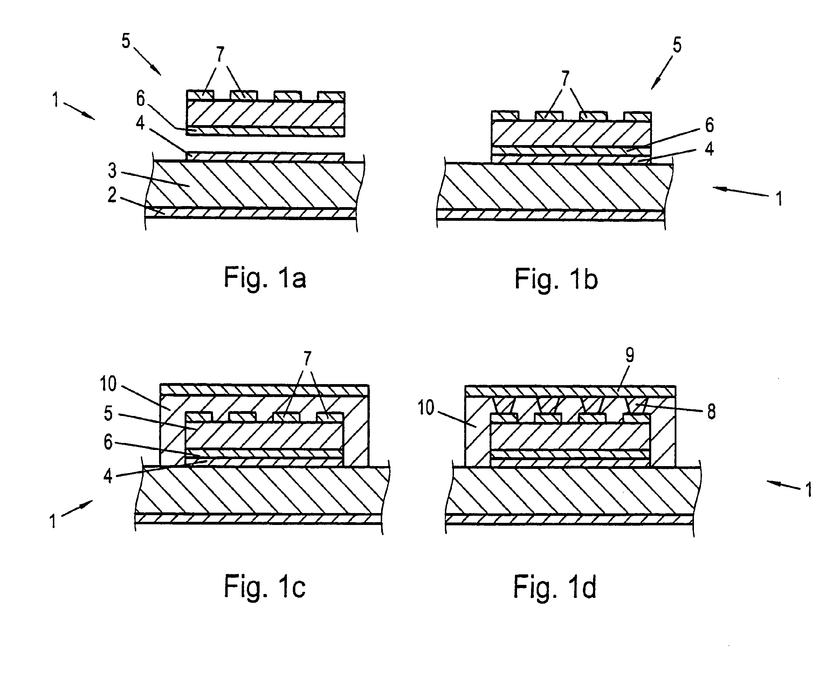

In Fig. 1 ist jeweils ein Teilbereich einer schematisch mit 1 bezeichneten Leiterplatte dargestellt, wobei die mehrlagige Struktur der Leiterplatte 1 lediglich durch Vorsehen einer leitenden bzw. leitfähigen Schicht 2, einer isolierenden bzw. nicht-leitenden Schicht 3 sowie einer leitenden bzw. leitfähigen Schicht 4 angedeutet ist, wobei, wie dies nachfolgend erörtert werden wird, ein Element bzw. Bauteil 5 mit dem Teilbereich der leitenden bzw. leitfähigen Schicht 4 der Leiterplatte 1 zu verbinden ist.

Entsprechend dem Einsatzzweck bzw. einer gegebenenfalls vorgesehenen Herstellung der Leiterplatte 1 in vorangehenden, nicht näher dargestellten Herstellungsschritten kann eine entsprechend größere Anzahl von Schichten bzw. Lagen für die Leiterplatte 1 vorgesehen sein.

Eine Verbindung zwischen der leitenden bzw. leitfähigen Schicht 4 der Leiterplatte 1 und dem Bauteil bzw. Element 5 zwischen der leitenden bzw. der leitfähigen Schicht 4 der Leiterplatte 1 und einer metallischen Oberfläche 6 des Bauteils 5 erfolgt durch ein Ultraschallschweißen bzw. ein hochfrequentes Reibschweißen. Hierbei wird durch eine nicht näher dargestellte Sonotrode bzw. einen Hochfrequenz-Schwingkopf auf die miteinander zu verbindenden Bauteile bzw. Schichten oder Flächen 4 eine Schwingung angelegt, wobei durch die durch die Schwingung erzeugte Molekularund Grenzflächenreibung eine Temperaturerhöhung der miteinander zu verbindenden Schichten 4 und 6 erzielt wird. Durch die Erwärmung, welche üblicherweise nicht bis zu einem Schmelzen der miteinander zu verbindenden Oberflächen 4 und 6 durchgeführt wird, erfolgt im wesentlichen eine Verzahnung der miteinander zu verbindenden Oberflächen bzw. Schichten 4 und 6, wie dies in Fig. 1b dargestellt ist.

Der Hochfrequenz-Schwingkopf kann hierbei bei einer Frequenz von 20 kHz und beispielsweise einer Auslenkung von 5 µm betrieben werden.

Durch das Reibschweißen bzw. Ultraschallschweißen erfolgt eine zuverlässige mechanische Verbindung zwischen der leitenden bzw. leitfähigen Schicht 4 der Leiterplatte 1 und der metallischen Oberfläche bzw. Schicht 6 des hiermit zu koppelnden Bauteils bzw. Elements 5, wodurch eine sichere mechanische Verbindung zwischen den miteinander zu verbindenden Schichten 4 und 6 als auch beispielsweise eine elektrisch als auch thermisch leitfähige Verbindung zur Verfügung gestellt wird.

Nach einer Festlegung des Elements bzw. Bauteils 5 erfolgt insbesondere zum Schutz des Bauteils 5 und gegebenenfalls zur Einbettung in weitere Schichten bzw. Lagen der Leiterplatte 1, welche nicht näher dargestellt sind, eine Umhüllung bzw. Ummantelung des Bauteils 5, wie dies in Fig. 1c dargestellt ist. Hierbei wird bei der dargestellten Ausführungsform der Bauteil 5 im wesentlichen vollständig durch ein isolierendes Material 10 ummantelt, wonach nachfolgend auf eine Ausbildung einer derartigen Ummantelung 10 eine Kontaktierung zwischen Kontakten 7 des Bauteils bzw. Elements 5 und Kontakten 8 mit einer zusätzlichen leitenden Schicht bzw. Lage 9 der Leiterplatte 1 erfolgt.

Es lässt sich somit durch ein hochfrequentes Reibschweißen bzw. Ultraschallschweißen eine mechanisch stabile und zuverlässige Verbindung bzw. Flächen 4 und 6 als auch eine entsprechend hohe, gegebenenfalls erforderliche thermische und elektrische Leitfähigkeit zur Verfügung stellen.

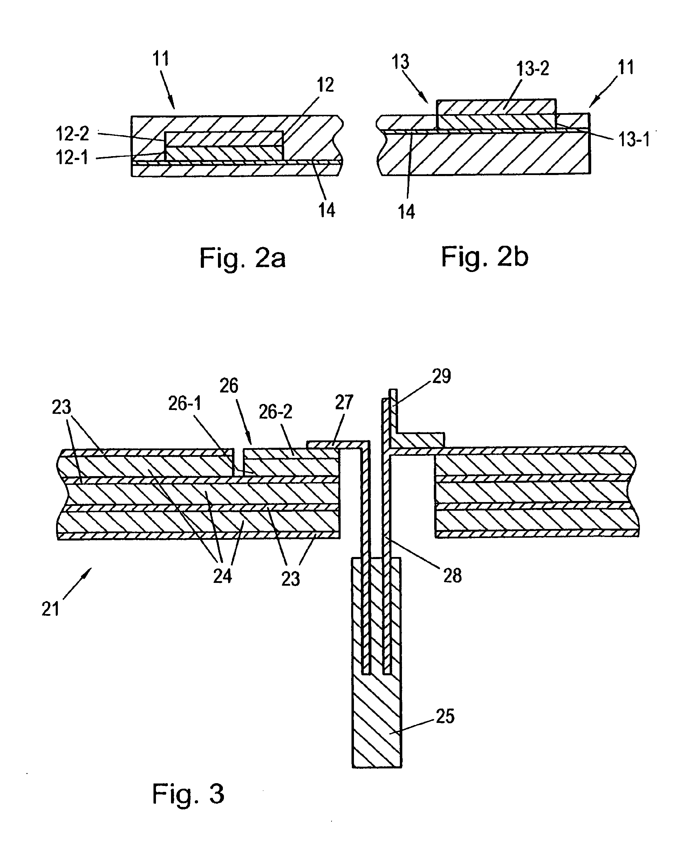

In Fig. 2a und 2b sind abgewandelte Ausführungsformen einer jeweils mit 11 bezeichneten Leiterplatte dargestellt.

An bzw. in der Leiterplatte 11 wird ein jeweils von einem mehrlagigen Leiterplattenelement 12 bzw. 13 gebildetes Element in bzw. an der Leiterplatte 11 festgelegt, wobei eine Verbindung jeweils über eine schematisch dargestellte leitende bzw. leitfähige Schicht 14 oder einen Teilbereich hievon der Leiterplatte 11 vorgenommen wird. Das in bzw. an der Leiterplatte 11 festzulegende Element bzw. Leiterplattenelement 12 bzw. 13 besteht, wie dies schematisch angedeutet ist, aus unterschiedlichen Lagen bzw. Schichten 12-1 und 12-2 bzw. 13-1 und 13-2 aus unterschiedlichen leitenden Materialien, insbesondere Metallen. Beispielsweise bestehen die Schichten bzw. Lagen 12-1 und 13-1 aus Kupfer oder einer kupferhaltigen Legierung, um in einfacher und zuverlässiger Weise eine Verbindung mit der leitenden bzw. leitfähigen Schicht 14 der Leiterplatte 11 zu erzielen, wobei derartige leitende bzw. leitfähige Schichten 14 üblicherweise aus Kupfer hergestellt sind.

Für eine Verbindung mit einem weiteren externen Bauteil, wie dies beispielsweise in Fig. 3 gezeigt ist, besteht die Schicht bzw. Lage 12-2 des Leiterplattenelements 12 oder die Schicht 13-2 des Leiterplattenelements 13 aus einem von Kupfer oder einem kupferhaltigen Material verschiedenen Material, wie beispielsweise Aluminium oder einer Aluminiumlegierung, um in weiterer Folge mit einem externen Bauteil, wie dies insbesondere unter Bezugnahme auf Fig. 3 im Detail erörtert werden wird, verbunden und gekoppelt zu werden.

Bei der Ausführung gemäß Fig. 2 erfolgt die Verbindung zwischen der Schicht 12-1 oder 13-1 mit der leitenden bzw. leitfähigen Schicht 14 der Leiterplatte 11 durch ein hochfrequentes Reibschweißen oder Ultraschallschweißen, wodurch wiederum eine mechanisch stabile und eine gute Leitfähigkeit aufweisende Verbindung zur Verfügung gestellt wird.

In Fig. 3 ist eine mehrlagige Leiterplatte 21 dargestellt, wobei einzelne leitende Schichten bzw. Lagen derselben mit 23 sowie dazwischen liegende Schichten bzw. Lagen aus einem nicht leitenden bzw. isolierenden Material mit 24 bezeichnet sind. Für eine Kopplung mit einer Energieversorgung, beispielsweise einer Batterie 25 ist ein wiederum mehrlagiges Element bzw. Leiterplattenelement 26 zur Verbindung mit einer Elektrode 27 der Batterie 25 vorgesehen, während eine Kopplung mit einer zweiten Elektrode 28 über eine Lötstelle bzw. ein L-förmiges Lötprofil 29 erfolgt. Für die Kopplung der aus Aluminium bzw. einer Aluminiumlegierung bestehenden Elektrode 27 besteht das Element bzw. Leiterplattenelement 26 wiederum aus einer Schicht bzw. Lage 26-1 aus Kupfer bzw. einem kupferhaltigen Material sowie einer Schicht bzw. Lage 26-2 aus Aluminium oder einem aluminiumhaltigen Material, wodurch in einfacher und zuverlässiger Weise eine Kopplung bzw. Verbindung der aus Aluminium bestehenden Elektrode 27 mit einem leitenden bzw. leitfähigen Bereich 23 der Leiterplatte 21 möglich wird, während demgegenüber ein mechanisches Verbinden beispielsweise durch Löten zwischen der aus Kupfer bestehenden Schicht 23 der Leiterplatte 21 und der Elektrode 27 aus Aluminium nicht möglich wäre.

Anstelle der Lötstelle 29 für die Verbindung bzw. Kopplung mit der beispielsweise aus Nickel bestehenden oder mit Nickel beschichteten Elektrode 28 könnte ähnlich zu dem mehrlagigen Leiterplattenelement 26 ein weiteres Element bzw. Leiterplattenelement in die Leiterplatte 21 integriert sein, wobei wiederum eine erste Schicht bzw. Lage aus Kupfer bzw. kupferhaltigem Material mit einer leitenden Schicht 23 der Leiterplatte 21 verbunden ist, während für eine unmittelbare Kopplung mit der aus Nickel bestehenden oder mit Nickel beschichteten Elektrode 28 die zweite Schicht bzw. Lage eines derartigen mehrlagigen Leiterplattenelements aus Nickel bzw. einem nickelhaltigen Material besteht.

Für eine mechanisch stabile und gut leitende bzw. leitfähige Verbindung erfolgt auch bei der Ausführungsform gemäß Fig. 3 die Festlegung eines von einem mehrlagigen Leiterplattenelement gebildeten Bauteil bzw. Element 26 durch ein hochfrequentes Reibschweißen bzw. Ultraschallschweißen ähnlich der Ausführungsform gemäß Fig. 1a bis 1d.

Als Materialien der Oberflächen bzw. Metallschichten des Bauteils 5 und der Schichten bzw. Lagen 12-1 bzw. 12-2, 13-1 bzw. 13-2, sowie 26-1 bzw. 26-2 des Elements bzw. Leiterplattenelements 12, 13 oder 26 können folgende Materialien gewählt werden: Kupfer, Aluminium, Nickel, Zinn, Zink, Titan, Silber, Gold, Palladium, Vanadium, Chrom, Magnesium, Eisen, Stahl, Edelstahl und Indium.

Anstelle von Reinmaterialien können auch Legierungen der oben angeführten Materialien verwendet werden.

Die Auswahl der für die mehrlagigen Elemente bzw. Leiterplattenelemente 12, 13 oder 26 eingesetzten Materialien erfolgt insbesondere im Hinblick auf die damit zu verbindenden Elemente bzw. Teilbereiche in der Leiterplatte 11 bzw. 21 als auch eines damit zu verbindenden bzw. zu koppelnden externen Bauteils 25, wobei beispielsweise für ein derartiges mehrlagiges Leiterplattenelement 12, 13 oder 26 folgende Materialkombinationen Verwendungen finden können, wobei sich die zusätzlichen Angaben auf Gewichtsprozent eines derartigen mehrlagigen Leiterplattenelements beziehen:
Aluminium-Kupfer (80/20)
Aluminium-Nickel (70/30)
Kupfer-Nickel (60/40)
Kupfer-Zink (75/25)
Kupfer-Nickel-Kupfer (40/20/40)

Neben den in den Figuren dargestellten Bauteilen bzw. Elementen oder externen Bauteilen, wie beispielsweise dem Bauteil oder der Halbleiterkomponente 5 oder Batterie 15 kann insbesondere über die mehrlagigen Leiterplattenelemente 12, 13 oder 26 eine Kopplung beispielsweise mit folgenden externen bzw. zusätzlichen Bauteilen vorgenommen werden: Li-Ionen Akkumulatoren und Folienbatterien mit Zellfahnen aus Aluminium und/oder Kupfer, Halbleiterkomponenten, wie beispielsweise ESD-Dioden, Kondensatoren oder dgl., welche insbesondere mit einer Aluminium-Endoberfläche oder Aluminiumkontakten versehen sind, Kühlelementen, oder allgemein Vorrichtungen für eine Verbesserung der Wärmeabfuhr von einer Leiterplatte, welche beispielsweise Komponenten mit hoher Verlustwärme enthält, wie beispielsweise LED, MOSFET oder dgl.

Darüber hinaus kann insbesondere bei Verwendung von mehrlagigen Elementen bzw. Leiterplattenelementen 12, 13 oder 26 neben einer Kopplung bzw. Verbindung zwischen der leitenden bzw. leitfähigen Schicht 14 bzw. 23 der Leiterplatte 11 bzw. 21 und der zugewandten metallischen Oberfläche 12-1, 13-1 oder 26-1 des damit zu verbindenden in bzw. an der Leiterplatte festzulegenden Bauteils bzw. Elements 12, 13 oder 26 eine Kopplung bzw. Verbindung oder Festlegung des zusätzlichen externen Bauteils, wie beispielsweise Elektroden 27 oder 28 der Batterie 25 ebenfalls durch ein hochfrequentes Reibschweißen oder Ultraschallschweißen bei einem geeigneten Material bzw. geeigneten Materialkombinationen der Elektroden und der damit zu verbindenden metallischen Oberfläche des mehrlagigen Elements bzw. Leiterplattenelements vorgenommen werden.

## Patentansprüche

1. Verfahren zum Festlegen eines wenigstens eine metallische Oberfläche (6, 12-1, 13-1, 26-1) aufweisenden Elements bzw. Bauteils (5, 12, 13, 26) in bzw. an einer Leiterplatte (1, 11, 21), welche wenigstens eine leitende Schicht (4, 14, 23) aus metallischem Material enthält, wobei eine Verbindung zwischen der wenigstens einen metallischen Oberfläche (6, 12-1, 13-1, 26-1) des Elements (5, 12, 13, 26) und der wenigstens einen leitenden Schicht (4, 14, 23) der Leiterplatte (1, 11, 21) durch ein Ultraschallschweißen bzw. hochfrequentes Reibschweißen durchgeführt wird, **dadurch gekennzeichnet, dass** das in bzw. an der Leiterplatte (11, 21) festgelegte Element (12, 13, 26) von einem Bi- oder Trimetallsubstrat gebildet ist, wobei eine zu der wenigstens einen Schicht (14, 23) aus leitendem Material der Leiterplatte (11, 21) gerichtete Schicht (12-1, 13-1, 26-1) des Elements (12, 13, 26) aus Kupfer oder einer Cu-haltigen Legierung gebildet wird.

2. Verfahren nach Anspruch 1, **dadurch gekennzeichnet, dass** eine von der zu der wenigstens einen Schicht (14, 23) aus leitendem Material der Leiterplatte (11, 21) gerichteten Schicht (12-1, 13-1, 26-1) abgewandte Schicht (12-2, 13-2, 26-2) des Elements (12, 13, 26) aus einem von Kupfer verschiedenen Metall, insbesondere aus Aluminium oder einer Aluminiumlegierung gebildet wird.

3. Verfahren nach Anspruch 1 oder 2, **dadurch gekennzeichnet, dass** das Leiterplattenelement (12, 13, 26) aus Metallen mit einer hohen, im wesentlichen ähnlichen bzw. gleichen Wärmeleitfähigkeit gebildet wird.

4. Verfahren nach Anspruch 1, 2 oder 3, **dadurch gekennzeichnet, dass** eine im wesentlichen vollflächige Verbindung zwischen der metallischen Oberfläche (6, 12-1, 13-1, 26-1) des Elements (5, 12, 13, 26) und der leitenden Schicht (4, 15, 23) der Leiterplatte (1, 11, 21) ausgebildet wird.

5. Verfahren nach einem der Ansprüche 1 bis 4, **dadurch gekennzeichnet, dass** nach einer Verbindung zwischen der metallischen Oberfläche (6) des Elements (5) und der leitenden Schicht (4) der Leiterplatte (1) eine wenigstens teilweise Ummantelung bzw. Einbettung (10) des mit der leitenden Schicht (4) der Leiterplatte (1) verbundenen Elements (5) ausgebildet wird.

6. Verfahren nach einem der Ansprüche 1 bis 5, **dadurch gekennzeichnet, dass** insbesondere nach der Verbindung, insbesondere nach einer Ummantelung bzw. Einbettung (10) des mit der leitenden Schicht (4) der Leiterplatte (1) verbundenen Elements (5) in an sich bekannter Weise eine Kontaktierung (7, 8, 9) des Elements vorgenommen wird.

7. Verfahren nach einem der Ansprüche 1 bis 6, **dadurch gekennzeichnet, dass** das Element von einem Leiterplattenelement (12, 13, 26) gebildet wird, welches wenigstens zwei Schichten bzw. Lagen (12-1, 12-2, 13-1, 13-2, 26-1, 26-2) aus unterschiedlichen leitenden Materialien, insbesondere Metallen, enthält bzw. daraus besteht.

8. Verfahren nach einem der Ansprüche 1 bis 7, **dadurch gekennzeichnet, dass** die metallische Oberfläche (12-1, 12-2, 13-1, 13-2, 26-1, 26-2) oder eine Lage des in bzw. an der Leiterplatte festgelegten Elements (12, 13, 26) mit einem externen Bauteil (25) verbunden wird.

9. Verfahren nach einem der Ansprüche 1 bis 8, **dadurch gekennzeichnet, dass** die metallische Oberfläche (6) bzw. wenigstens eine Schicht bzw. Lage (12-1, 12-2, 13-1, 13-2, 26-1, 26-2) des in bzw. an der Leiterplatte (1, 11, 21) festgelegten Elements (5, 12, 13, 26) gewählt wird aus der Gruppe, umfassend Kupfer, Aluminium, Nickel, Zinn, Zink, Titan, Silber, Gold, Palladium, Vanadium, Chrom, Magnesium, Eisen, Stahl, Edelstahl und Indium als Reinmaterial oder Legierung(en) hievon.

10. Leiterplatte, welche wenigstens eine leitende Schicht (4, 14, 23) aus metallischem Material enthält, wobei die Leiterplatte (1, 11, 21) ein wenigstens eine metallische Oberfläche (6, 12-1, 13-1, 26-1) aufweisendes Element bzw. Bauteil (5, 12, 13, 26) umfasst, wobei die metallische Oberfläche (6, 12-1, 13-1, 26-1) des Elements (5, 12, 13, 26) bzw. Bauteils mit der wenigstens einen leitenden Schicht (4, 14, 23) der Leiterplatte (1, 11, 21) durch ein Ultraschallschweißen bzw. hochfrequentes Reibschweißen verbunden ist, **dadurch gekennzeichnet, dass** das in bzw. an der Leiterplatte (11, 21) festgelegte Element (12, 13, 26) von einem Bi- oder Trimetallsubstrat gebildet ist, wobei eine zu einer Schicht (14, 28) aus leitendem Material der Leiterplatte (11, 21) gerichtete Schicht (12-1, 13-1, 26-1) aus Kupfer oder einer Cu-haltigen Legierung gebildet ist.

11. Leiterplatte nach Anspruch 10, **dadurch gekennzeichnet, dass** eine von der zu der wenigstens einen Schicht (14, 23) aus leitendem Material der Leiterplatte (11, 21) gerichteten Schicht (12-1, 13-1, 26-1) abgewandte Schicht (12-2, 13-2, 26-2) des Leiterplattenelements (12, 13, 26) aus einem von Kupfer verschiedenen Metall, insbesondere aus Aluminium oder einer Aluminiumlegierung gebildet ist.

12. Leiterplatte nach Anspruch 10 oder 11, **dadurch gekennzeichnet, dass** das Leiterplattenelement (12, 13, 26) aus Metallen mit einer hohen, im wesentlichen ähnlichen bzw. gleichen Wärmeleitfähigkeit gebildet ist.

13. Leiterplatte nach Anspruch 10, 11 oder 12, **dadurch gekennzeichnet, dass** eine im wesentlichen vollflächige Verbindung zwischen der metallischen Oberfläche (6, 12-1, 13-1, 26-1) des Elements (5, 12, 13, 26) und der leitenden Schicht (4, 14, 23) der Leiterplatte (1, 11, 21) vorgesehen ist.

14. Leiterplatte nach Anspruch 11 oder 12, **dadurch gekennzeichnet, dass** das Element von einem Leiterplattenelement (12, 13, 26) gebildet ist, welches wenigstens zwei Schichten bzw. Lagen (12-1, 12-2, 13-1, 13-2, 26-1, 26-2) aus unterschiedlichen leitenden Materialien, insbesondere Metallen, enthält oder daraus besteht.

15. Leiterplatte nach einem der Ansprüche 10 bis 14, **dadurch gekennzeichnet, dass** die metallische Oberfläche (6) bzw. wenigstens eine Schicht bzw. Lage (12-1, 12-2, 13-1, 13-2, 26-1, 26-2) des in bzw. an der Leiterplatte (1, 11, 21) festgelegten Elements (5, 12, 13, 26) gewählt ist aus der Gruppe, umfassend Kupfer, Aluminium, Nickel, Zinn, Zink, Titan, Silber, Gold, Palladium, Vanadium, Chrom, Magnesium, Eisen, Stahl, Edelstahl und Indium als Reinmaterial oder Legierung(en) hievon.

## Claims

1. A method for mounting an element or component (5, 12, 13, 26) having at least one metal surface (6, 12-1, 13-1, 26-1) in or on a circuit board (1, 11, 21) containing at least one conducting layer (4, 14, 23) made of metal material, wherein a connection between the at least one metal surface (6, 12-1, 13-1, 26-1) of the element (5, 12, 13, 26) and the at least one conducting layer (4, 14, 23) of the circuit board (1, 11, 21) is formed using ultrasonic welding or high-frequency friction welding, **characterized in that** the element (12, 13, 26) mounted in or on the circuit board (11, 21) is formed by a bi- or tri-metal substrate, wherein a layer (12-1, 13-1, 26-1) of the element (12, 13, 26) facing the at least one layer (14, 23) of conducting material of the circuit board (11, 21) is formed by copper or a Cu-containing alloy.

2. A method according to claim 1, **characterized in that** a layer (12-2, 13-2, 26-2) of the element (12, 13, 26) facing away from the layer (12-1, 13-1, 26-1) facing the at least one layer (14, 23) of conducting material of the circuit board (11, 21) is formed by a metal different from copper, in particular aluminum or an aluminum alloy.

3. A method according to claim 1 or 2, **characterized in that** the circuit board element (12, 13, 26) is formed by metals having high, substantially similar or identical, thermal conductivities.

4. A method according to claim 1, 2 or 3, **characterized in that** a substantially full-surface connection is formed between the metal surface (6, 12-1, 13-1, 26-1) of the element (5, 12, 13, 26) and the conducting layer (4, 14, 23) of the circuit board (1, 11, 21).

5. A method according to any of the claims 1 to 4, **characterized in that** an at least partial sheathing or embedment (10) of the element (5) connected to the conducting layer (4) of the circuit board (1) is formed after having connected the metal surface (6) of the element (5) and the conducting layer (4) of the circuit board (1).

6. A method according to any of the claims 1 to 5, **characterized in that** bonding (7, 8, 9) of the element (5) connected to the conducting layer (4) of the circuit board (1) is performed in a manner known per se, in particular after having formed the connection and, in particular, the sheathing or embedment of the element.

7. A method according to any one of claims 1 to 6, **characterized in that** the element is formed by a circuit board element (12, 13, 26) containing, or consisting of, at least two layers or plies (12-1, 12-2, 13-1, 13-2, 26-1, 26-2) of different conducting materials, in particular metals.

8. A method according to any one of claims 1 to 7, **characterized in that** the metal surface (12-1, 12-2, 13-1, 13-2, 26-1, 26-2) or a ply of the element (12, 13, 26) mounted in or on the circuit board is connected to an external component (25).

9. A method according to any one of claims 1 to 8, **characterized in that** the metal surface (6), or the at least one layer or ply (12-1, 12-2, 13-1, 13-2, 26-1, 26-2), of the element (5, 12, 13, 26) mounted in or on the circuit board (1, 11, 21) is selected from the group consisting of copper, aluminum, nickel, tin, zinc, titanium, silver, gold, palladium, vanadium, chromium, magnesium, iron, steel, stainless steel and indium as pure materials or alloy(s) thereof.

10. A circuit board containing at least one conducting layer (4, 14, 23) made of metal material, wherein the circuit board (1, 11, 21) comprises an element or component (5, 12, 13, 26) having at least one metal surface (6, 12-1, 13-1, 26-1), wherein the metal surface (6, 12-1, 13-1, 26-1) of the element (5, 12, 13, 26) or component is connected to the at least one conducting layer (4, 14, 23) of the circuit board (1, 11, 21) using ultrasonic welding or high-frequency friction welding, **characterized in that** the element (12, 13, 26) mounted in or on the circuit board (11, 21) is formed of a bi- or tri-metal substrate, wherein a layer (12-1, 13-1, 26-1) facing a layer (14, 28) of conducting material of the circuit board (11, 21) is formed of copper or a Cu-containing alloy.

11. A circuit board according to claim 10, **characterized in that** a layer (12-2, 13-2, 26-2) of the circuit board element (12, 13, 26) facing away from the layer (12-1, 13-1, 26-1) facing the at least one layer (14, 23) of conducting material of the circuit board (11, 21) is formed of a metal different from copper, in particular aluminum or an aluminum alloy.

12. A circuit board according to claim 10 or 11, **characterized in that** the circuit board element (12, 13, 26) is formed of metals having high, substantially similar or identical, thermal conductivities.

13. A circuit board according to claim 10, 11 or 12, **characterized in that** a substantially full-surface connection is provided between the metal surface (6, 12-1, 13-1, 26-1) of the element (5, 12, 13, 26) and the conducting layer (4, 14, 23) of the circuit board (1, 11, 21).

14. A circuit board according to claim 11 or 12, **characterized in that** the element is comprised of a circuit board element (12, 13, 26) containing, or consisting of, at least two layers or plies (12-1, 12-2, 13-1, 13-2, 26-1, 26-2) of different conducting materials, in particular metals.

15. A circuit board according to any of the claims 10 to 14, **characterized in that** the metal surface (6), or the at least one layer or ply (12-1, 12-2, 13-1, 13-2, 26-1, 26-2), of the element (5, 12, 13, 26) mounted in or on the circuit board (1, 11, 21) is selected from the group consisting of copper, aluminum, nickel, tin, zinc, titanium, silver, gold, palladium, vanadium, chromium, magnesium, iron, steel, stainless steel and indium as pure materials or alloy(s) thereof.

## Revendications

1. Procédé servant à fixer un élément ou un composant (5, 12, 13, 26) présentant au moins une surface métallique (6, 12-1, 13-1, 26-1) dans une carte de circuits imprimés (1, 11, 21) ou au niveau de cette dernière, laquelle contient au moins une strate (4, 14, 23) conductrice fabriquée en un matériau métallique, sachant que la surface métallique (6, 12-1, 13-1, 26-1) au moins au nombre de une de l'élément (5, 12, 13, 26) et la strate (4, 14, 23) conductrice au moins au nombre de une de la carte de circuits imprimés (1, 11, 21) sont assemblées par un soudage par ultrasons ou par un soudage par friction à haute fréquence, **caractérisé en ce que** l'élément (12, 13, 26) fixé dans la carte de circuits imprimés (11, 21) ou au niveau de cette dernière est formé par un substrat bimétallique ou trimétallique, sachant qu'une strate (12-1, 13-1, 26-1), orientée en direction de la strate (14, 23) au moins au nombre de une fabriquée en un matériau conducteur de la carte de circuits imprimés (11, 21), de l'élément (12, 13, 26) est formée à partir de cuivre ou d'un alliage contenant du Cu.

2. Procédé selon la revendication 1, **caractérisé en ce qu'**une strate (12-2, 13-2, 26-2), opposée à la strate (12-1, 13-1, 26-1) orientée en direction de la strate (14, 23) au moins au nombre de une fabriquée en un matériau conducteur de la carte de circuits imprimés (11, 21), de l'élément (12, 13, 26) est formée à partir d'un métal autre que le cuivre, en particulier à partir de l'aluminium ou d'un alliage à base d'aluminium.

3. Procédé selon la revendication 1 ou 2, **caractérisé en ce que** l'élément de carte de circuits imprimés (12, 13, 26) est formé à partir de métaux présentant une conductivité thermique élevée, essentiellement similaire ou identique.

4. Procédé selon la revendication 1, 2 ou 3, **caractérisé en ce que** l'assemblage entre la surface métallique (6, 12-1, 13-1, 26-1) de l'élément (5, 12, 13, 26) et la strate (4, 15, 23) conductrice de la carte de circuits imprimés (1, 11, 21) est réalisé essentiellement sur toute la surface.

5. Procédé selon l'une quelconque des revendications 1 à 4, **caractérisé en ce qu'**on réalise, une fois l'assemblage entre la surface métallique (6) de l'élément (5) et la strate (4) conductrice de la carte de circuits imprimés (1) effectué, un gainage ou un emballage (10) au moins partiel de l'élément (5) relié à la strate (4) conductrice de la carte de circuits imprimés (1).

6. Procédé selon l'une quelconque des revendications 1 à 5, **caractérisé en ce qu'**une mise en contact (7, 8, 9) de l'élément est effectuée d'une manière connue en soi en particulier après l'assemblage, en particulier après un gainage ou un emballage (10) de l'élément (5) assemblé à la strate (4) conductrice de la carte de circuits imprimés (1).

7. Procédé selon l'une quelconque des revendications 1 à 6, **caractérisé en ce que** l'élément est formé par un élément de carte de circuits imprimés (12, 13, 26), lequel contient au moins deux strates ou couches (12-1, 12-2, 13-1, 13-2, 26-1, 26-2) fabriquées à partir de divers matériaux conducteurs ou en est constitué.

8. Procédé selon l'une quelconque des revendications 1 à 7, **caractérisé en ce que** la surface métallique (12-1, 12-2, 13-1, 13-2, 26-1, 26-2) ou une couche de l'élément (12, 13, 26) fixé dans la carte de circuits imprimés ou au niveau de cette dernière est assemblée à un composant (25) externe.

9. Procédé selon l'une quelconque des revendications 1 à 8, **caractérisé en ce que** la surface métallique (6) ou au moins une strate ou couche (12-1, 12-2, 13-1, 13-2, 26-1, 26-2) de l'élément (5, 12, 13, 26) fixé dans la carte de circuits imprimés (1, 11, 21) ou au niveau de cette dernière est choisie parmi le groupe comprenant le cuivre, l'aluminium, le nickel, l'étain, le zinc, le titane, l'argent, l'or, le palladium, le vanadium, le chrome, le magnésium, le fer, l'acier, l'acier inoxydable et l'indium en tant que matériau pur ou un ou des alliages de ces derniers.

10. Carte de circuits imprimés, qui contient au moins une strate (4, 14, 23) conductrice fabriquée à partir d'un matériau métallique, sachant que la carte de circuits imprimés (1, 11, 21) comprend un élément ou un composant (5, 12, 13, 26) présentant une surface métallique (6, 12-1, 13-1, 26-1), sachant que la surface métallique (6, 12-1, 13-1, 26-1) de l'élément (5, 12, 13, 26) ou du composant est assemblée à la strate (4, 14, 23) conductrice au moins au nombre de une de la carte de circuits imprimés (1, 11, 21) par un soudage par ultrasons ou par un soudage par friction à haute fréquence, **caractérisée en ce que** l'élément (12, 13, 26) fixé dans ou au niveau de la carte de circuits imprimés (11, 21) est formé par un substrat bimétallique ou trimétallique, sachant qu'une strate (12-1, 13-1, 26-1) orientée vers une strate (14, 28) fabriquée à partir d'un matériau conducteur de la carte de circuits imprimés (11, 21) est formée à partir de cuivre ou d'un alliage contenant du Cu.

11. Carte de circuits imprimés selon la revendication 10, **caractérisée en ce qu'**une strate (12-2, 13-2, 26-2), opposée à la strate (12-1, 13-1, 26-1) orientée vers la strate (14, 23) au moins au nombre de une fabriquée à partir d'un matériau conducteur de la carte de circuits imprimés (11, 21), de l'élément de carte de circuits imprimés (12, 13, 26) est formée par un métal autre que le cuivre, en particulier par de l'aluminium ou par un alliage d'aluminium.

12. Carte de circuits imprimés selon la revendication 10 ou 11, **caractérisée en ce que** l'élément de cartes de circuits imprimés (12, 13, 26) est formé à partir de métaux présentant une conductivité thermique élevée, essentiellement similaire ou identique.

13. Carte de circuits imprimés selon la revendication 10, 11, ou 12, **caractérisée en ce qu'**un assemblage de la surface métallique (6, 12-1, 13-1, 26-1) de l'élément (5, 12, 13, 26) à la strate (4, 14, 23) conductrice de la carte de circuits imprimés (1, 11, 21) est prévu essentiellement sur toute la surface.

14. Carte de circuits imprimés selon la revendication 11 ou 12, **caractérisée en ce que** l'élément est formé par un élément de carte de circuits imprimés (12, 13, 26), lequel contient au moins deux strates ou couches (12-1, 12-2, 13-1, 13-2, 26-1, 26-2) fabriquées à partir de divers matériaux conducteurs, en particulier à partir de métaux, ou en est constitué.

15. Carte de circuits imprimés selon l'une quelconque des revendications 10 à 14, **caractérisée en ce que** la surface métallique (6) ou au moins une strate ou couche (12-1, 12-2, 13-1, 13-2, 26-1, 26-2) de l'élément (5, 12, 13, 26) fixé dans la carte de circuits imprimés (1, 11, 21) ou au niveau de cette dernière est choisie parmi le groupe comprenant le cuivre, l'aluminium, le nickel, l'étain, le zinc, le titane, l'argent, l'or, le palladium, le vanadium, le chrome, le magnésium, le fer, l'acier, l'acier inoxydable et l'indium en tant que matériau pur ou un ou des alliages de ces derniers.
